# EUROPEAN PATENT SPECIFICATION

(11) **EP 4 049 321 B1**
(45) Date of publication and mention of the grant of the patent: **09.08.2023**
(21) Application number: 19795506.5
(22) Date of filing: 23.10.2019
(51) Int. Cl.: H10N 10/13, F24H 3/02, F24D 19/10

(54) **THERMOELECTRIC GENERATOR AND ITS APPLICATIONS**
THERMOELEKTRISCHER GENERATOR UND SEINE ANWENDUNGEN
GÉNÉRATEUR THERMOÉLECTRIQUE ET SES APPLICATIONS

(43) Date of publication of application: 31.08.2022
(73) Proprietor: Calidi AS, 1266 Oslo (NO)
(72) Inventor: HELLERUD, Wiggo R., 1405 Langhus (NO); BENTSEN, Marius, Leonard Norum, 1452 Nesoddtangen (NO)
(74) Representative: Onsagers AS
(86) International application number: PCT/EP2019/078858
(87) International publication number: WO 2021/078376

(56) References cited:
- WO-A1-2014/161551
- JP-A- 2005 057 908
- US-A- 3 056 848
- US-A- 3 129 116
- US-A1- 2005 172 992
- US-A1- 2006 053 771
- US-A1- 2013 152 562
- US-A1- 2015 075 160

## Description

### Introduction

The present invention relates to a thermoelectric generator designed for providing high power efficiency as well as a method for making this. It further relates to a system comprising the thermoelectric generator connected to a heater. The solution is suited for keeping an environment at a controlled temperature without providing external power supply for longer periods of time.

### Background

Thermoelectric generators are well known in the art. These are used for different purposes. One example is for powering electrical operation devices of heaters.

Heaters can be used in environments where different kinds of goods and products are to be stored at a specific and controlled temperature over long periods of time. An example of this is storing of medicines and utility equipment at a non-freezing temperature in a container or trailer placed in a field.

Use of heaters running on fossil fuel is well known for keeping an environment at a specific temperature. An example of such a heater is a diesel heater that can be made relative compact for fitting into different environments such as for instance a boat, a vehicle, a container or camper.

There are different types of heaters running on fossil fuel. A diesel heater typically comprises an air inlet for leading air into a fan impeller and a fuel pump feeding diesel to a diesel engine. Combustion air is led through an inlet, while exhaust is led through an outlet. The combustion air is heated by a diesel engine generating heated exhaust when running. The heated air is warming up air driven through the air fan impeller and heat exchangers, thereby producing warm air at an outlet.

The combustion of the diesel is controlled by sensors and an integrated control unit. The operation of a heater is controlled by an electrical operation device which function is to switch the heater on and off according to a set temperature.

Without access to external power, a battery is required for providing power to said electrical operation device, and for starting the diesel engine in the heater.

When a heater and its battery is installed in an environment for long periods of time and without access to an external power supply, the battery used must have sufficient capacity for providing power to the heater. Electric power consumption of a heater is dependent on how often it must start. This is in turn dependent on the temperature difference in the temperature-controlled environment where it is installed and the temperature outside the controlled environment. If the difference is big, the heater must be started more often, thereby requiring more power from a battery. Over time, the battery will become discharged. This may reduce the time an environment can be kept at a controlled temperature without access to external power or changing the battery. A battery with large capacity will provide power for operating for a longer time. Larger battery capacity does however normally mean a larger footprint that will not contribute to a compact solution.

To solve this problem there are different solutions for self-powered heater systems where heat generated by a heater is used by a thermoelectric generator for generating electric energy used for charging a battery connected to an electric operation device.

WO-2010074767A1 describes a heater utilizing a thermoelectric generator for charging a battery.

US-6527548B1 describes a heater comprising a thermoelectric generator used to power electric components, and to charge a battery.

US-5450869A describes an example of a self-powered heater system comprising a combustion unit, a fuel pump, a thermoelectric converter, a battery and means for recharging the battery from the thermoelectric converter.

US-2005204762A1 discloses an exhaust gas heat recovery system comprising a thermoelectric generator for recharging a battery. The thermoelectric generator elements are arranged in an exhaust passage.

US-2010227286A1 describes a catalytic heater utilizing a thermoelectric generator (thermopile) to power electric components and recharging a battery.

WO-2011130373A2 discloses a heating device comprising a combustion unit, a rechargeable battery and a thermoelectric generator, which generator may be used to recharge the battery.

Said publications represent examples of different types thermoelectric generators used for charging a rechargeable battery of a heater system. None of the solutions described in the publications above do however provide sufficient power to fully charge a battery from the heat generated by a heater when running, i.e. the residual heat generated by a heater is not sufficiently utilized for generating electrical energy necessary to fully charge a battery.

Furthermore US 2005/172992 A1 (SHIMOJI KOUJI [JP] ET AL) 11 August 2005 (2005-08-11) discloses a thermoelectric generator arranged around a catalytic converter. US 2006/053771 A1 (MURATA KIYOHITO [JP]) 16 March 2006 (2006-03-16) discloses an exhaust system including a thermoelectric generator. WO 2014/161551 A1 (ALPCON AS [DK]) 9 October 2014 (2014-10-09) discloses as portable air heating system comprising a burner and a thermoelectric generator.

Known solutions are thus not well suited for installation in an environment without access to an external power supply for longer periods of time. They are further not suited to being retrofitted to a heater system while keeping a small footprint.

The present invention is defined by a thermoelectric generator having constructional features making it suitable to be retrofitted to an existing heater such as a fuel heater. When the heater is running it will generate waste heat from its exhaust outlet. This heat is efficiently utilized in the thermoelectric generator having the constructional features according to the invention that will provide sufficient power to a charging device for fully charging a rechargeable battery. The battery used for providing power to the heater can be relatively small since the thermoelectric generator provides high power efficiency such that the battery will be fully charged each time the heater is running.

The constructional features of the thermoelectric generator according to the invention makes it well suited for being retro-fitted to a heater while requiring minimal additional space or footprint. Examples of areas of use are installations that must be held at a non-freezing temperature. These may be stationary or mobile installations.

The solution provided by the present invention makes it possible to store different kinds of goods and products in a temperature-controlled environment for long periods of time, such as several months. The solution is therefore well suited for being used at locations without access to an external power supply.

The thermoelectric generator is further well suited to be used in conjunction with a heater and a closed loop pipe with circulating water, such as in a radiator or water-born floor heating. In this way heated air from the heater is used for heating a room, while heated circulating water is heating for instance a floor in a water-born floor heating. This combination provides a good and comfortable indoor climate in for example a camper or leisure boat.

### Summary of the invention

The present invention is defined by a thermoelectric generator according to claim 1, providing high power efficiency. It is well suited to be used in conjunction with a heater for keeping an environment at a controlled temperature without providing external power supply. The thermoelectric generator comprises several interacting elements. These are:
- a heat distributor having a longitudinal internal passage with a heat sink for guiding a hot gas stream from an inlet of the heat distributor to an outlet of the heat distributor, the heat sink comprises several ribs where the hot gas stream passes between them from the heat distributor inlet to the heat distributor outlet, where the heat distributor inlet is connected to the heat distributor by means of a first lid and a first sealing, and the heat distributor outlet is connected to the heat distributor by means of a second lid and a second sealing;
- at least two thermoelectric elements placed and connected diametrically to each other to the heat distributor, where each thermoelectric element has a hot side and a cold side, where the hot side is connected to the heat distributor and the cold side is connected to a water cooler block with an inlet cooler connection and outlet cooler connection, the water cooler block comprises a cooler base with a plurality of cooler pins extending from the cooler base to a cooler base lid connected to the inlet cooler connection and the outlet cooler connection; wherein
- the heat distributor is extruded in one piece having a quadratic shape and where each internal wall is provided with the heat sink comprising ribs of different heights such that the cross section of the heat distributor has ribs making a star shaped pattern;
- the cooler pins extend from the cooler base to a cooler base lid have a rectangular shape;
- pressure pads are connected to tightening screws supported by a fitting ring, for pressing the water cooler blocks against the at least two thermoelectric elements;
- a first water pipe is connected to the inlet cooler connection of each water cooler block, and a second water pipe connected to the outlet cooler connection of each water cooler block;
said elements are enclosed in a housing provided with a bushing for electrical connections to the thermoelectric elements; and where a material having low thermal conductivity is provided between the housing and the heat distributor.

In a preferred embodiment, the heat distributor has a cross section with heat sink ribs making a star shaped pattern, and where a solid heat sink insert is placed in the center of the heat distributor forcing air flow to flow between the heat sink ribs.

The present invention further comprises a system according to claim 4, providing a temperature-controlled environment without supplying external power supply, the system comprises a heater running on fossil fuel, an electrical operation device connected to the heater, thermostatic elements and a rechargeable battery connected to an output of a battery charger and with a thermoelectric generator connected to an input of the battery charger, and where the thermoelectric generator comprises the elements described above and where the heat distributor inlet is connected to a gas stream outlet of the heater, and where the first and second water pipes are connected to a closed loop pipe with a water pump for circulating water.

According to one embodiment, the closed loop pipe is a radiator or water-born floor heating, and the temperature-controlled environment is arranged in a container or trailer boat or vehicle. In this way heat from water output from the water cooling block can be emitted by a radiator and cooled water will be circulated back to the water cooling block.

The invention is further defined by a method for making a thermoelectric generator according to claim 9, having interacting elements providing high power efficiency. The method comprises the following steps:
providing a heat distributor having a longitudinal internal passage with a heat sink for guiding a hot gas stream from an inlet of the heat distributor to an outlet of the heat distributor, the heat sink comprises several ribs where the hot gas stream pass between them from the heat distributor inlet to the heat distributor outlet, where the heat distributor inlet is connected to the heat distributor by means of a first lid and a first sealing, and the heat distributor outlet is connected to the heat distributor by means of a second lid and a second sealing;
- providing at least two thermoelectric elements and placing them diametrically to each other and connecting hot sides of the thermoelectric elements to the heat distributor and cold sides to a water cooler block having an inlet cooler connection and outlet cooler connection, the water cooler block comprises a cooler base with a plurality of cooler pins extending from the cooler base to a cooler base lid connected to the inlet cooler connection and the outlet cooler connection,
- extruding the heat distributor in one piece having a quadratic shape and providing each internal wall is provided with the heat sink comprising ribs of different heights such that the cross section of the heat distributor has ribs making a star shaped pattern;
- applying pressure pads connected to tightening screws and supporting the tightening screws by means of a fitting ring;
- pressing the water cooler blocks against the at least two thermoelectric elements by means of the pressure pads;
- connecting a first water pipe to the inlet cooler connection of each water cooler block, and connecting a second water pipe to the outlet cooler connection of each water cooler block;
- enclosing said interacting elements of the thermoelectric generator in a housing, where the housing is provided with a bushing for electrical connections to the thermoelectric elements;
- filling a material having a low thermal conductivity between the housing and the heat distributor.

Further features of the method are defined in the claims.

### Detailed description

Thermoelectric elements are well known solid-state devices that converts heat flux (temperature differences) directly into electrical energy through a thermoelectric effect occurring when there is a temperature difference across a module, i.e. by heating one side (the hot side) of the module and cooling an opposite side (the cold side). The thermoelectric elements preferably used in the present invention are utilizing the Seebeck effect where heat is directly converted into electricity at the junction of two different types of wires. A thermoelectric element can be made flat and small and have no moving parts.

A thermoelectric generator according to the present invention provides maximum utilization of thermoelectric elements by providing optimal coupling of the hot side of thermoelectric elements to a specially designed heat distributor for a hot gas stream and optimal coupling of the cold side to a water cooler block with circulating water. In addition to using power generated by the thermoelectric elements for charging a battery, circulating water exiting the water cooler block can be used for heating before being cooled and returned at the input of the water cooling block.

The different elements of the thermoelectric generator will now be described in detail with reference to the figures in were:
Figure 1A - 1D illustrate constructional features of an embodiment of the heat distributor;
Figure 2 illustrates the heat distributor with connected inlet and outlet and thermoelectric elements.
Figure 3 illustrates an embodiment comprising four water cooler blocks;
Figure 4 illustrates constructional features of the water cooler block;
Figure 5 illustrates pressure pads, tightening screws and fitting ring used for pressing the water blocks to the thermoelectric elements.
Figure 6 illustrates connection of water pipes to the water cooler blocks;
Figure 7 illustrates parts of a housing enclosing the elements of the thermoelectric generator;
Figure 8 illustrates an assembled thermoelectric generator according to the invention, and
Figure 9 illustrates a system comprising the thermoelectric generator according to the invention.

The present invention comprises a thermoelectric generator with at least two thermoelectric elements. The example used and illustrated in the figures comprises four thermoelectric elements connected a quadratic shaped heat distributor as well as other features used for explaining the claimed invention defined in the main claims.

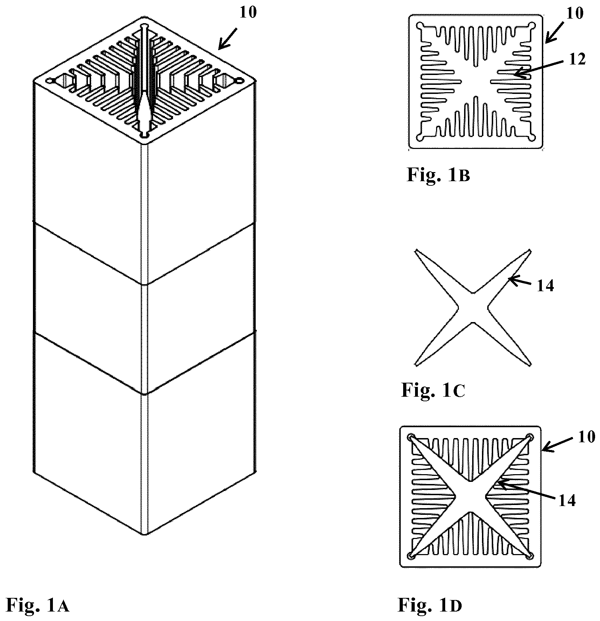

Figure 1A - 1D illustrate constructional features of an embodiment of the heat distributor 10 comprised in the thermoelectric generator 70. Figure 1A shows an example of a heat distributor 10 with a longitudinal internal passage provided with a heat-sink 12 for guiding hot gas stream from a heat distributor inlet 20 to a heat distributor outlet 26. Figure 1B illustrates constructional features of the heat sink 12. In this embodiment, the cross-section of the heat distributor 10 shows that the heat-sink 12 comprises several ribs that are made in a star shaped pattern, i.e. the ribs have different heights from the inner wall of the heat distributor 10 where they are projecting from. This embodiment can be extruded from one piece of heat conducting material, such as for instance aluminium, copper or silver. If the hot gas stream has a high temperature, other material withstanding the temperature must be used.

For further improving the heat conducting properties of the heat distributor 10, a star shaped solid heat sink insert 14 is placed in the center of the heat distributor 10. The heat sink insert 14 is made of the same material as the heat distributor 10. This serves two purposes. The first purpose is that all parts of a hot gas stream will be forced to pass the heat sink 12 thereby providing optimal conducing of heat to the outer surface of the heat distributor 10. The second purpose is that that the total mass of the heat distributor increases, thereby increasing absorbed heat quantity properties.

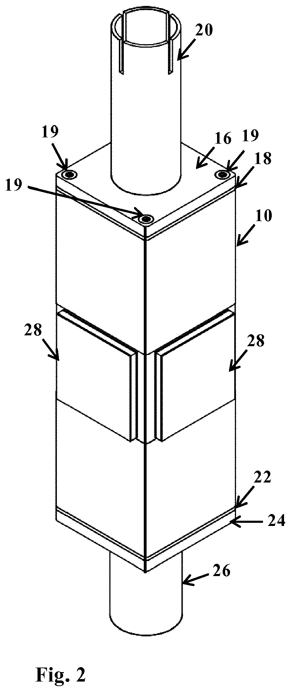

Figure 2 illustrates the heat distributor 10 with connected heat distributor inlet 20 and heat distributor outlet 26 as well as thermoelectric elements 28 placed diametrically to each other on the heat distributor 10. A thermoelectric element 28 has a hot side and a cold side. The temperature difference between each side determine the efficiency of the thermoelectric element 28, i.e. how much power that is generated. The hot side of each thermoelectric element 28 is connected to the heat distributor 10.

The heat distributor inlet 20 is connected to the heat distributor 10 by means of a first lid 16, a first sealing 18 and securing bolts 19. The heat distributor outlet 26 is connected to the heat distributor 10 by means of a second lid 24, a second sealing 22 and securing bolts.

The size of the heat distributor 20 depends on the amount and temperature of the hot gas that is guided into to the heat distributor inlet 20, i.e. the sized depends on the amount of energy in the hot gas. The heat distributor 20 may for instance have a length of 150mm and a width of 50mm. The efficiency of the heat distributor 20 is dependent on its physical measures.

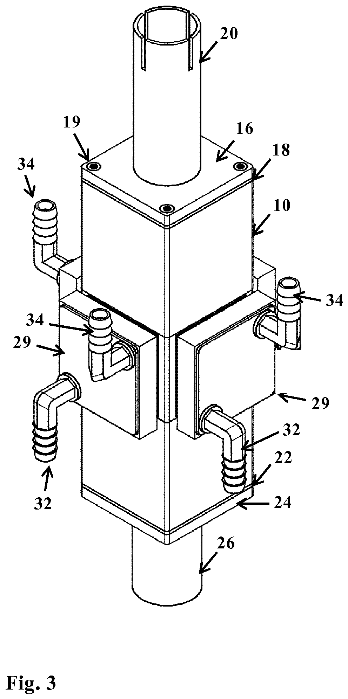

Figure 3 illustrates an embodiment of the thermoelectric generator 70 comprising four water cooler blocks 29 connected to the cold side of the thermoelectric elements 28. The water cooler blocks 29 comprises an inlet cooler connection 32 and outlet cooler connection 34 for connecting water pipes.

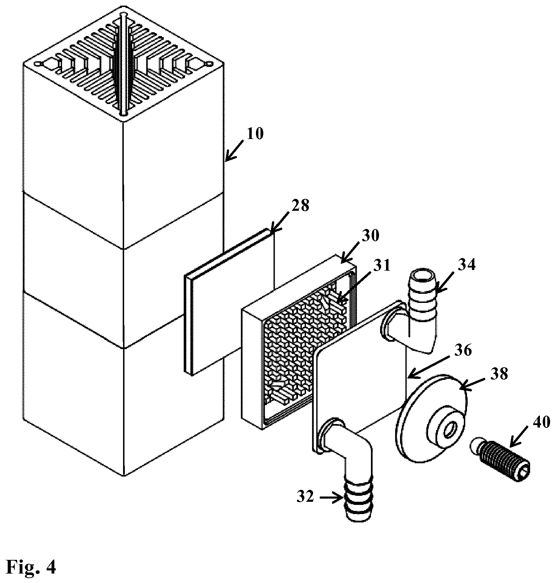

Figure 4 illustrates preferred constructional features of a water cooler block 29 providing high cooling efficiency. The water cooler block 29 comprises a cooler base 30 with plurality of cooler pins 31 and a cooler base lid 36 connected to the inlet cooler connection 32 and the outlet cooler connection 34.

According to the invention, the cooler pins 31 have a rectangular shape and extend from the cooler base 30 to the cooler base lid 36. In this way, it will conduct heat from the cooler base 30 to the cooler base lid 30 via the cooler pins 31.

This shape of the cooler pins 31 serve two purposes, where the first is to provide maximum cooling area on each pin and the second purpose is to puncture and crush possible air bubbles by means of its sharp edges.

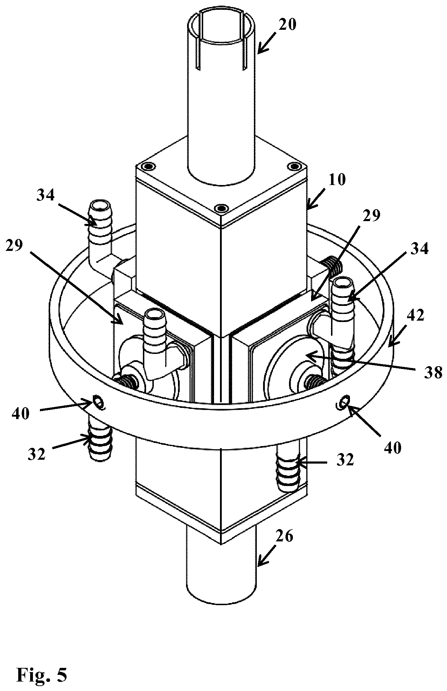

The figure also shows a pressure pad 38 and tightening screw 40 explained below. Figure 5 illustrates how the water cooler blocks 29 are positioned and pressed against the thermoelectric elements 28 and the heat distributor 10 by means of pressure pads 38, tightening screws 40 and a fitting ring 42. This configuration enables high contact and accurate pressure to be applied to the thermoelectric elements. The pressure applied is adjusted according to the specifications of the thermoelectric elements used, e.g. a typical contact pressure for a Seebeck module should be between 3-8 kg/cm².

The pressure pads 29 are made in a heat isolating material such that heat from the water cooler block 29 will not be transferred to the pressure pads 29. The materiel must further be strong such as for instance POM (Polyoxymethylene). The fitting ring 42 is typically made of steel.

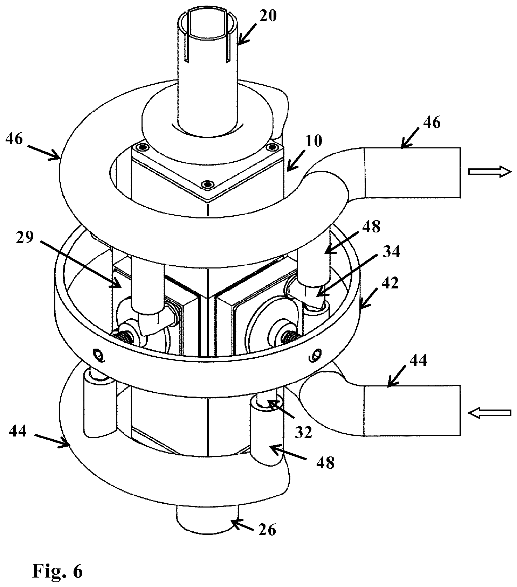

Figure 6 illustrates how the water pipes are connected to the water cooler blocks 29. A first water pipe 44 is connected to the inlet cooler connection 32 of each water cooler block 29, and a second water pipe 46 is connected to the outlet cooler connection 34 of each water cooler block 29. The first and second water pipes have water pipe connections 48 adapted for fitting the inlet and outlet cooler connections 32, 34.

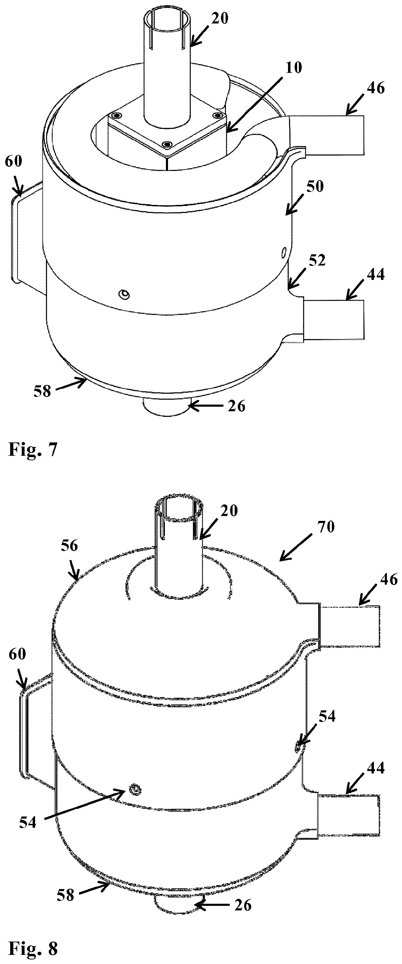

Figure 7 illustrates parts of a housing for enclosing the elements of the thermoelectric generator 70 in the position it is intended to be installed when in use. That is, the heat distributor inlet 20 is pointing upwards and the heat distributor outlet 26 is pointing downwards relative to a vertical axis running through them.

In the embodiment shown, the housing comprises an upper housing 50, a lower housing 52 and a bottom housing 58. In another embodiment, the upper housing 50 and the lower housing 52 are made as one part and not two separate parts. The housing is provided with a bushing for guiding electrical wires from the thermoelectric elements 28 to a connection box 60 on the outside of the housing. Between the housing and the heat distributor 10 there is an isolation material. This is a material with low thermal conductivity, such as for instance Aerogel, and where this is applied as Aerogel boards, moulded Aerogel or Aerogel in a granulate form. Other types of materials or combination of materials tolerating the exposed heat are also feasible. The materials used are preferably in the form of granulate.

Figure 8 illustrates a fully assembled thermoelectric generator 70 according to the invention where a top housing 56 is installed after the isolation material has been fitted.

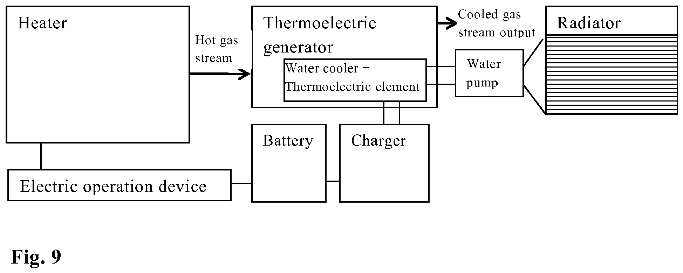

Figure 9 illustrates a system comprising the thermoelectric generator 70 according to the invention. The system provides a temperature-controlled environment without need to supply external power. The system comprises a heater running on fossil fuel, an electric operation device connected to the heater and a rechargeable battery connected to an output of a battery charger and where a thermoelectric generator 70 is connected to an input of the battery charger. The electric operation device typically comprises a master controller connected to a temperature controller receiving power from the chargeable battery. The electric operation device will start and stop the heater based on a set temperature for the temperature-controlled environment.

Ideally the rechargeable battery is fully charged at all time, thereby providing sufficient energy to the electric operation device for long periods of time, i.e. several months. This is possible by using the thermoelectric generator 70 according to the invention.

The thermoelectric generator 70 provides high power efficiency when assembled and build with the different elements described above thereby producing sufficient power for keeping a battery fully charged by the heat from the heater.

The heat distributor inlet 20 of the thermoelectric generator 70 is connected to a hot gas stream outlet of the heater, i.e. in the case of a fossil fuel heater, the exhaust outlet of the heater. The first and second water pipes 44, 46 are connected to a closed loop pipe with a water pump for circulating water. The heat distributor outlet 26 will output a cooled gas stream, i.e. cooled exhaust.

The system is suited for installation in any environment. It is well suited for installation in environments with little space. The closed loop pipe may for instance be a radiator or water-born floor heating installed in a container, trailer, vehicle or boat. The system described above providing the temperature-controlled environment can easily be installed and connected to an existing circulating water system.

Heaters are typically driven by 12V or 24V depending on in which environment they are installed. The voltage of the chargeable battery used, and the charging voltage is adjusted accordingly.

The present invention is also defined by a method for making a thermoelectric generator 70 having interacting elements providing high power efficiency.

The thermoelectric generator 70 is made by providing a heat distributor 10 having a longitudinal internal passage with a heat sink 12 for guiding hot gas stream from a heat distributor inlet 20 to a heat distributor outlet 26.

The next step is providing two or more thermoelectric elements 28 and placing them diametrically to each other and connecting the hot sides of the thermoelectric elements 28 to the heat distributor 10 and the cold sides to a water cooler block 29 having an inlet cooler connection 32 and outlet cooler connection 34.

In one embodiment, the heat distributor 10 can be extruded in one piece having a quadratic shape and providing each internal wall with a heat sink 12 comprising ribs of different heights such that the cross section of the heat distributor 10 shows ribs has a star shaped pattern. In this case four thermoelectric elements 28 are used, i.e. one on each side of the heat distributor 10.

The next step is applying pressure pads 38 connected to tightening screws 40 and supporting the tightening screws 40 by means of a fitting ring 42, and then pressuring the water cooler blocks 29 against the at least two thermoelectric elements 28 by means of the pressure pads 38. A torque wrench can be used for applying the right pressure.

The next step is connecting a first water pipe 44 to the inlet cooler connection 32 of each water cooler block 29 and connecting a second water pipe 46 to the outlet cooler connection 34 of each water cooler block 29.

The different interacting elements of the thermoelectric generator 70 are then enclosed in a housing, were the housing is provided with a bushing for electrical wires to the thermoelectric elements 28.

At last an isolation material is filled between the housing and the heat distributor 10 before fully closing the hosing. The type of material is the one mentioned above.

The described method provides a thermoelectric generator 70 for optimally utilizing heat from a hot gas stream. An example of this is connecting the thermoelectric generator 70 to a gas stream outlet of a heater operated by an electrical operation device connected to thermostatic elements and a rechargeable battery with a battery charger, and connecting the first and second water pipes 44, 46 to a closed loop pipe with a water pump for circulating water. This will provide a temperature-controlled system suited for keeping an environment at a controlled temperature without providing external power supply.

When performing all method steps above, an environment can be temperature controlled for long periods of time without providing external power supply.

### Figure references

10 - heat distributor
12 - heat sink
14 - heat sink insert
16 - first lid
18 - first sealing
19 - securing bolts
20 - heat distributor inlet
22 - second sealing
24 - second lid
26 - heat distributor outlet
28 - thermoelectric element
29 - water cooler block
30 - cooler base (totally isolated from 10)
31 - cooler pins
32 - inlet cooler connection
34 - outlet cooler connection
36 - cooler base lid
38 - pressure pad
40 - tightening screw
42 - fitting ring
44 - first water pipe
46 - second water pipe
48 - water pipe connection
50 - upper housing
52 - lower housing
54 - fixing bolt
56 - top housing
58 - bottom housing
60 - connection box
70 - thermoelectric generator

## Claims

1. A thermoelectric generator (70), comprising the following elements:
- a heat distributor (10) having a longitudinal internal passage with a heat sink (12) for guiding a hot gas stream from an inlet (20) of the heat distributor (10) to an outlet (26) of the heat distributor (10), the heat sink (12) comprises several ribs where the hot gas stream passes between them from the heat distributor inlet (20) to the heat distributor outlet (26), where the heat distributor inlet (20) is connected to the heat distributor (10) by means of a first lid (16) and a first sealing (18), and the heat distributor outlet (26) is connected to the heat distributor (10) by means of a second lid (24) and a second sealing (22);
- at least two thermoelectric elements (28) placed and connected diametrically to each other to the heat distributor (10), where each thermoelectric element (28) has a hot side and a cold side, where the hot side is connected to the heat distributor (10) and the cold side is connected to a water cooler block (29) with an inlet cooler connection (32) and outlet cooler connection (34), the water cooler block (29) comprises a cooler base (30) with a plurality of cooler pins (31) extending from the cooler base (30) to a cooler base lid (36) connected to the inlet cooler connection (32) and the outlet cooler connection (34);
**characterized in that**
- the heat distributor (10) is extruded in one piece having a quadratic shape and where each internal wall is provided with the heat sink (12) comprising ribs of different heights such that the cross section of the heat distributor (10) has ribs making a star shaped pattern;
- the cooler pins (31) extend from the cooler base (30) to a cooler base lid (36) have a rectangular shape;
- pressure pads (38) are connected to tightening screws (40) supported by a fitting ring (42), for pressing the water cooler blocks (29) against the at least two thermoelectric elements (28);
- a first water pipe (44) is connected to the inlet cooler connection (32) of each water cooler block (29), and a second water pipe (46) connected to the outlet cooler connection (34) of each water cooler block (29);
said elements are enclosed in a housing provided with a bushing for electrical connections to the thermoelectric elements (28); and where a material having low thermal conductivity is provided between the housing and the heat distributor (10).

2. The thermoelectric generator (70) according to claim 1,
**characterized in that** a star shaped solid heat sink insert (14) is placed in the centre of the heat distributor (10).

3. The thermoelectric generator (70) according to claim 1 or 2, where the material having low thermal conductivity is Aerogel.

4. A system providing a temperature-controlled environment, the system comprises a heater running on fossil fuel, an electrical operation device connected to the heater and a rechargeable battery connected to an output of a battery charger,
**characterized in that** a thermoelectric generator (70) according to claims 1 to 3 is connected to an input of the battery charger,
and where the heat distributor inlet (20) is connected to a gas stream outlet of the heater, and where the first and second water pipes (44, 46) are connected to a closed loop pipe with a water pump for circulating water.

5. The system according to claim 4, where the closed loop pipe is a radiator.

6. The system according to claim 4 or 5, where the temperature-controlled environment is arranged in a container or trailer.

7. The system according to claim 4 or 5, where the temperature-controlled environment is arranged in a boat.

8. The system according to claim 4 or 5, where the temperature-controlled environment is arranged in a vehicle.

9. A method for making a thermoelectric generator (70) having interacting elements, by:
- providing a heat distributor (10) having a longitudinal internal passage with a heat sink (12) for guiding a hot gas stream from an inlet (20) of the heat distributor (10) to an outlet (26) of the heat distributor (10), the heat sink (12) comprises several ribs where the hot gas stream pass between them from the heat distributor inlet (20) to the heat distributor outlet (26), where the heat distributor inlet (20) is connected to the heat distributor (10) by means of a first lid (16) and a first sealing (18), and the heat distributor outlet (26) is connected to the heat distributor (10) by means of a second lid (24) and a second sealing (22);
- providing at least two thermoelectric elements (28) and placing them diametrically to each other and connecting hot sides of the thermoelectric elements (28) to the heat distributor (10) and cold sides to a water cooler block (29) having an inlet cooler connection (32) and outlet cooler connection (34), the water cooler block (29) comprises a cooler base (30) with a plurality of cooler pins (31) extending from the cooler base (30) to a cooler base lid (36) connected to the inlet cooler connection (32) and the outlet cooler connection (34), **characterized by**
- extruding the heat distributor (10) in one piece having a quadratic shape and providing each internal wall is provided with the heat sink (12) comprising ribs of different heights such that the cross section of the heat distributor (10) has ribs making a star shaped pattern;
- applying pressure pads (38) connected to tightening screws (40) and supporting the tightening screws (40) by means of a fitting ring (42);
- pressing the water cooler blocks (29) against the at least two thermoelectric elements (28) by means of the pressure pads (38);
- connecting a first water pipe (44) to the inlet cooler connection (32) of each water cooler block (29), and connecting a second water pipe (46) to the outlet cooler connection (34) of each water cooler block (29);
- enclosing said interacting elements of the thermoelectric generator (70) in a housing, where the housing is provided with a bushing for electrical connections to the thermoelectric elements (28);
- filling a material having a low thermal conductivity between the housing and the heat distributor (10).

10. The method according to claim 9, by further connecting the thermoelectric generator (70) to a gas stream outlet of a heater operated by an electrical operation device connected to thermostatic elements and a rechargeable battery with a battery charger, and connecting the first and second water pipes (44, 46) to a closed loop pipe with a water pump for circulating water and thereby providing a temperature-controlled system.

11. The method according to claim 10, by installing system comprising the thermoelectric generator (70) in an environment to be temperature controlled.

## Patentansprüche

1. Thermoelektrischer Generator (70), umfassend die folgenden Elemente:
einen Wärmeverteiler (10) mit einem länglichen Innenkanal mit einem Kühlkörper (12) zum Leiten eines Heißgasstroms von einem Eingang (20) des Wärmeverteilers (10) zu einem Ausgang (26) des Wärmeverteilers (10), wobei der Kühlkörper (12) mehrere Rippen umfasst, zwischen denen der Heißgasstrom vom Wärmeverteilereingang (20) zum Wärmeverteilerausgang (26) strömt, wobei der Wärmeverteilereingang (20) mit dem Wärmeverteiler (10) durch einen ersten Deckel (16) und eine erste Dichtung (18) verbunden ist und der Wärmeverteilerausgang (26) mit dem Wärmeverteiler (10) durch einen zweiten Deckel (24) und eine zweite Dichtung (22) verbunden ist;
wenigstens zwei diametral zueinander angeordnete und mit dem Wärmeverteiler (10) verbundene thermoelektrische Elemente (28), wobei jedes thermoelektrische Element (28) eine warme Seite und eine kalte Seite aufweist, wobei die warme Seite mit dem Wärmeverteiler (10) verbunden ist und die kalte Seite mit einem Wasserkühlerblock (29) mit einer Eingangskühlerverbindung (32) und Ausgangskühlerverbindung (34) verbunden ist, wobei der Wasserkühlerblock (29) eine Kühlerbasis (30) mit einer Vielzahl von sich von der Kühlerbasis (30) zu einem mit der Eingangskühlerverbindung (32) und der Ausgangskühlerverbindung (34) verbundenen Kühlerbasisdeckel (36) erstreckenden Kühlerstiften (31) umfasst;
**dadurch gekennzeichnet, dass**
der Wärmeverteiler (10) in einem Teil mit einer quadratischen Form extrudiert ist, wobei jede Innenwand mit dem Rippen in unterschiedlichen Höhen umfassenden Kühlkörper (12) ausgestattet ist, so dass der Querschnitt des Wärmeverteilers (10) ein sternförmiges Muster bildende Rippen aufweist;
sich die Kühlerstifte (31) von der Kühlerbasis (30) zu einem Kühlerbasisdeckel (36) mit einer rechteckigen Form erstrecken;
Druckstücke (38) mit von einem Montagering (42) gestützten Festziehschrauben (40) verbunden sind, um die Wasserkühlerblöcke (29) gegen die wenigstens zwei thermoelektrischen Elemente (28) zu drücken;
ein erstes Wasserrohr (44) mit der Eingangskühlerverbindung (32) von jedem Wasserkühlerblock (29) verbunden ist und ein zweites Wasserrohr (46) mit der Ausgangskühlerverbindung (34) von jedem Wasserkühlerblock (29) verbunden ist;
die Elemente in einem mit einer Buchse für elektrische Verbindungen mit den thermoelektrischen Elementen (28) ausgestatteten Gehäuse verschlossen sind, wobei ein Material mit niedriger Wärmeleitfähigkeit zwischen dem Gehäuse und dem Wärmeverteiler (10) angeordnet ist.

2. Thermoelektrischer Generator (70) nach Anspruch 1,
**dadurch gekennzeichnet, dass** ein sternförmiger massiver Kühlkörpereinsatz (14) in der Mitte des Wärmeverteilers (10) angeordnet ist.

3. Thermoelektrischer Generator (70) nach Anspruch 1 oder 2, wobei das Material mit niedriger Wärmeleitfähigkeit Aerogel ist.

4. Eine temperaturgesteuerte Umgebung herstellendes System, wobei das System ein mit fossilem Brennstoff betriebenes Heizgerät, eine mit dem Heizgerät verbundene elektrische Betriebsvorrichtung und eine mit einem Ausgang eines Batterieladegeräts verbundene wiederaufladbare Batterie umfasst,
**dadurch gekennzeichnet, dass** ein thermoelektrischer Generator (70) nach Anspruch 1 bis 3 mit einem Eingang des Batterieladegeräts verbunden ist, wobei der Wärmeverteilereingang (20) mit einem Gasstromausgang des Heizgeräts verbunden ist und das erste und zweite Wasserrohr (44, 46) mit einem Rohr mit einem geschlossenen Kreislauf und einer Wasserpumpe zum Umwälzen von Wasser verbunden sind.

5. System nach Anspruch 4, wobei das Rohr mit einem geschlossenen Kreislauf ein Heizkörper ist.

6. System nach Anspruch 4 oder 5, wobei die temperaturgesteuerte Umgebung in einem Container oder Anhänger angeordnet ist.

7. System nach Anspruch 4 oder 5, wobei die temperaturgesteuerte Umgebung in einem Boot angeordnet ist.

8. System nach Anspruch 4 oder 5, wobei die temperaturgesteuerte Umgebung in einem Fahrzeug angeordnet ist.

9. Verfahren zum Herstellen eines thermeoelektrischen Generators (70) mit Elementen in Wechselwirkung durch:
Bereitstellen eines Wärmeverteilers (10) mit einem länglichen Innenkanal mit einem Kühlkörper (12) zum Leiten eines Heißgasstroms von einem Eingang (20) des Wärmeverteilers (10) zu einem Ausgang (26) des Wärmeverteilers (10), wobei der Kühlkörper (12) mehrere Rippen umfasst, zwischen denen der Heißgasstrom vom Wärmeverteilereingang (20) zum Wärmeverteilerausgang (26) strömt, wobei der Wärmeverteilereingang (20) mit dem Wärmeverteiler (10) durch einen ersten Deckel (16) und eine erste Dichtung (18) verbunden ist und der Wärmeverteilerausgang (26) mit dem Wärmeverteiler (10) durch einen zweiten Deckel (24) und eine zweite Dichtung (22) verbunden ist;
Bereitstellen von wenigstens zwei thermoelektrischen Elementen (28) und Anordnen von diesen diametral zueinander und Verbinden von warmen Seiten der thermoelektrischen Elemente (28) mit dem Wärmeverteiler (10) und von kalten Seiten mit einem Wasserkühlerblock (29) mit einer Eingangskühlerverbindung (32) und Ausgangskühlerverbindung (34),
wobei der Wasserkühlerblock (29) eine Kühlerbasis (30) mit einer Vielzahl von sich von der Kühlerbasis (30) zu einem mit der Eingangskühlerverbindung (32) und der Ausgangskühlerverbindung (34) verbundenen Kühlerbasisdeckel (36) erstreckenden Kühlerstiften (31) umfasst, **gekennzeichnet durch**
Extrudieren des Wärmeverteiler (10) in einem Teil mit einer quadratischen Form und Ausstatten der Innenwand mit dem Rippen in unterschiedlichen Höhen umfassenden Kühlkörper (12), so dass der Querschnitt des Wärmeverteilers (10) ein sternförmiges Muster bildende Rippen aufweist; Anordnen von mit Festziehschrauben (40) verbundenen Druckstücken (38) und Stützen der Festziehschrauben (40) durch einen Montagering (42); Drücken der Wasserkühlerblöcke (29) gegen die wenigstens zwei thermoelektrischen Elemente (28) durch die Druckstücke (38); Verbinden eines ersten Wasserrohrs (44) mit der Eingangskühlerverbindung (32) von jedem Wasserkühlerblock (29) und Verbinden eines zweiten Wasserrohrs (46) mit der Ausgangskühlerverbindung (34) von jedem Wasserkühlerblock (29);
Umschließen der Elemente des thermoelektrischen Generators (70) in Wechselwirkung in einem Gehäuse, wobei das Gehäuse mit einer Buchse für elektrische Verbindungen mit den thermoelektrischen Elementen (28) ausgestattet ist;
Einfüllen eines Materials mit niedriger Wärmeleitfähigkeit zwischen dem Gehäuse und dem Wärmeverteiler (10).

10. Verfahren nach Anspruch 9, durch ferner Verbinden des thermoelektrischen Generators (70) mit einem Gasstromausgang eines von einer elektrischen Betriebsvorrichtung, verbunden mit thermostatischen Elementen und einer wiederaufladbaren Batterie mit einem Batterieladegerät, betriebenen Heizgeräts und Verbinden des ersten und zweiten Wasserrohrs (44, 46) mit einem Rohr mit einem geschlossenen Kreislauf zum Umwälzen von Wasser und dadurch Bereitstellen eines temperaturgesteuerten Systems.

11. Verfahren nach Anspruch 10, durch ferner Installieren des den thermoelektrischen Generator (70) umfassenden Systems in einer Umgebung, die einer Temperatursteuerung zu unterziehen ist.

## Revendications

1. Générateur thermoélectrique (70), comprenant les éléments suivants :
- un distributeur de chaleur (10) ayant un passage interne longitudinal avec un dissipateur de chaleur (12) pour guider un flux de gaz chaud depuis une entrée (20) du distributeur de chaleur (10) vers une sortie (26) du distributeur de chaleur (10), le dissipateur de chaleur (12) comprend plusieurs nervures où le flux de gaz chaud passe entre elles de l'entrée (20) de distributeur de chaleur à la sortie (26) de distributeur de chaleur, où l'entrée (20) de distributeur de chaleur est reliée au distributeur de chaleur (10) au moyen d'un premier couvercle (16) et d'un premier joint (18), et la sortie (26) de distributeur de chaleur est reliée au distributeur de chaleur (10) au moyen d'un deuxième couvercle (24) et d'un deuxième joint (22) ;
- au moins deux éléments thermoélectriques (28) placés et reliés de manière diamétrale l'un par rapport à l'autre au distributeur de chaleur (10), où chaque élément thermoélectrique (28) a un côté chaud et un côté froid, où le côté chaud est relié au distributeur de chaleur (10) et le côté froid est relié à un bloc de refroidisseur d'eau (29) avec une liaison de refroidisseur d'entrée (32) et une liaison de refroidisseur de sortie (34), le bloc de refroidisseur d'eau (29) comprend une base de refroidisseur (30) avec une pluralité de broches de refroidisseur (31) s'étendant de la base de refroidisseur (30) vers un couvercle (36) de base de refroidisseur relié à la liaison de refroidisseur d'entrée (32) et à la liaison de refroidisseur de sortie (34) ;
**caractérisé en ce que**
- le distributeur de chaleur (10) est extrudé en une seule pièce ayant une forme quadratique et où chaque paroi interne est munie du dissipateur de chaleur (12) comprenant des nervures de différentes hauteurs de sorte que la section transversale du distributeur de chaleur (10) présente des nervures créant un motif en forme d'étoile ;
- les broches de refroidisseur (31) s'étendant de la base de refroidisseur (30) à un couvercle (36) de base de refroidisseur ont une forme rectangulaire ;
- des tampons de pression (38) sont reliés à des vis de serrage (40) supportées par une bague de raccordement (42), pour presser les blocs de refroidisseur d'eau (29) contre les au moins deux éléments thermoélectriques (28) ;
- une première conduite d'eau (44) est reliée à la liaison de refroidisseur d'entrée (32) de chaque bloc de refroidisseur d'eau (29), et une deuxième conduite d'eau (46) reliée à la liaison de refroidisseur de sortie (34) de chaque bloc de refroidisseur d'eau (29) ;
lesdits éléments sont enfermés dans un boîtier muni d'une douille pour des liaisons électriques aux éléments thermoélectriques (28) ; et où un matériau ayant une faible conductivité thermique est prévu entre le boîtier et le distributeur de chaleur (10).

2. Générateur thermoélectrique (70) selon la revendication 1,
**caractérisé en ce qu'**un insert (14) de dissipateur de chaleur solide en forme d'étoile est placé au centre du distributeur de chaleur (10).

3. Générateur thermoélectrique (70) selon la revendication 1 ou 2, dans lequel le matériau à faible conductivité thermique est l'aérogel.

4. Système fournissant un environnement à température contrôlée, le système comprend un réchauffeur fonctionnant au combustible fossile, un dispositif d'actionnement électrique relié au réchauffeur et une batterie rechargeable reliée à une sortie d'un chargeur de batterie,
**caractérisé en ce qu'**un générateur thermoélectrique (70) selon les revendications 1 à 3 est relié à une entrée du chargeur de batterie, et dans lequel l'entrée (20) de distributeur de chaleur est reliée à une sortie de flux de gaz du réchauffeur, et dans lequel les première et deuxième conduites d'eau (44, 46) sont reliées à une conduite en boucle fermée avec une pompe à eau pour faire circuler l'eau.

5. Système selon la revendication 4, dans lequel la conduite en boucle fermée est un radiateur.

6. Système selon la revendication 4 ou 5, dans lequel l'environnement à température contrôlée est agencé dans un conteneur ou une remorque.

7. Système selon la revendication 4 ou 5, dans lequel l'environnement à température contrôlée est agencé dans un bateau.

8. Système selon la revendication 4 ou 5, dans lequel l'environnement à température contrôlée est agencé dans un véhicule.

9. Procédé de fabrication d'un générateur thermoélectrique (70) ayant des éléments en interaction, par :
- la fourniture d'un distributeur de chaleur (10) ayant un passage interne longitudinal avec un dissipateur de chaleur (12) pour guider un flux de gaz chaud depuis une entrée (20) du distributeur de chaleur (10) vers une sortie (26) du distributeur de chaleur (10), le dissipateur de chaleur (12) comprend plusieurs nervures où le flux de gaz chaud passe entre elles de l'entrée (20) de distributeur de chaleur à la sortie (26) de distributeur de chaleur, dans lequel l'entrée (20) de distributeur de chaleur est reliée au distributeur de chaleur (10) au moyen d'un premier couvercle (16) et d'un premier joint (18), et la sortie (26) de distributeur de chaleur est reliée au distributeur de chaleur (10) au moyen d'un deuxième couvercle (24) et d'un deuxième joint (22) ;
- la fourniture d'au moins deux éléments thermoélectriques (28) et la mise en place de ceux-ci de manière diamétrale l'un par rapport à l'autre et la liaison des côtés chauds des éléments thermoélectriques (28) au distributeur de chaleur (10) et des côtés froids à un bloc de refroidisseur d'eau (29) ayant une liaison de refroidisseur d'entrée (32) et une liaison de refroidisseur de sortie (34), le bloc de refroidisseur d'eau (29) comprend une base de refroidisseur (30) avec une pluralité de broches de refroidisseur (31) s'étendant de la base de refroidisseur (30) à un couvercle (36) de base de refroidisseur relié à la liaison de refroidisseur d'entrée (32) et à la liaison de refroidisseur de sortie (34),
**caractérisé par**
- l'extrusion du distributeur de chaleur (10) en une seule pièce ayant une forme quadratique et la fourniture, à chaque paroi interne, du dissipateur de chaleur (12) comprenant des nervures de différentes hauteurs de sorte que la section transversale du distributeur de chaleur (10) présente des nervures créant un motif en forme d'étoile ;
- l'application de tampons de pression (38) reliés à des vis de serrage (40) et supportant les vis de serrage (40) au moyen d'une bague de raccordement (42) ;
- la pression des blocs refroidisseurs d'eau (29) contre les au moins deux éléments thermoélectriques (28) au moyen des tampons de pression (38) ;
- la liaison d'une première conduite d'eau (44) à la liaison de refroidisseur d'entrée (32) de chaque bloc de refroidisseur d'eau (29), et la liaison d'une deuxième conduite d'eau (46) à la liaison de refroidisseur de sortie (34) de chaque bloc de refroidisseur d'eau (29) ;
- l'enfermement desdits éléments d'interaction du générateur thermoélectrique (70) dans un boîtier, dans lequel le boîtier étant muni d'une douille pour des liaisons électriques aux éléments thermoélectriques (28) ;
- l'introduction d'un matériau à faible conductivité thermique entre le boîtier et le distributeur de chaleur (10).

10. Procédé selon la revendication 9, **caractérisé en outre par** la liaison du générateur thermoélectrique (70) à une sortie de flux de gaz d'un réchauffeur actionné par un dispositif d'actionnement électrique relié à des éléments thermostatiques et une batterie rechargeable avec un chargeur de batterie, et la liaison des première et deuxième conduites d'eau (44, 46) à une conduite en boucle fermée avec une pompe à eau pour faire circuler l'eau et fournir ainsi un système à température contrôlée.

11. Procédé selon la revendication 10, **caractérisé par** l'installation du système comprenant le générateur thermoélectrique (70) dans un environnement à température contrôlée.
